(19) Europäisches Patentamt
European Patent Office
Office européen des brevets

(11) **EP 3 675 391 B1**

(12) **FASCICULE DE BREVET EUROPEEN**

(45) Date de publication et mention
de la délivrance du brevet:
**07.08.2024 Bulletin 2024/32**

(21) Numéro de dépôt: **19219444.7**

(22) Date de dépôt: **23.12.2019**

(51) Classification Internationale des Brevets (IPC):
*H04B 17/14* (2015.01)    *H04B 17/17* (2015.01)
*H04B 17/19* (2015.01)    *H04B 17/318* (2015.01)
*G01R 31/3185* (2006.01)    *H03H 11/54* (2006.01)

(52) Classification Coopérative des Brevets (CPC):
**H04B 17/14; H04B 17/17; H04B 17/19;**
**H04B 17/318;** G06F 30/34; H03H 2210/04

(54) **PROCÉDÉ POUR VÉRIFIER LE FONCTIONNEMENT D'UNE CHAINE RADIO**

VERFAHREN ZUM ÜBERPRÜFEN DER FUNKTIONSWEISE EINER FUNKKETTE

METHOD FOR VERIFYING THE OPERATION OF A RADIO CHANNEL

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **28.12.2018 FR 1874337**

(43) Date de publication de la demande:
**01.07.2020 Bulletin 2020/27**

(73) Titulaire: **THALES**
**92190 Meudon (FR)**

(72) Inventeurs:
• **PETIT, Maïté**
**49309 Cholet (FR)**
• **BOURSIER, Olivier**
**49309 Cholet (FR)**

(74) Mandataire: **Atout PI Laplace**
**Immeuble Up On**
**25 Boulevard Romain Rolland**
**CS 40072**
**75685 Paris Cedex 14 (FR)**

(56) Documents cités:
**WO-A1-2017/176778    US-A1- 2011 211 649**

EP 3 675 391 B1

## Description

L'invention concerne un procédé et un système permettant de vérifier le bon fonctionnement des composants d'une chaîne radio de façon autosuffisante. Elle est notamment utilisée dans le cadre de chaînes radio monovoie pilotées par un composant programmable ou FPGA (Field Programmable Gate Array) ou un composant similaire.

Elle peut aussi être utilisée pour le calibrage en ligne de composants présents dans un système. Elle s'applique, par exemple, pour le calibrage d'un filtre tractable, i.e., un filtre dont la fréquence centrale est variable, et pour un filtre tractable passe-bande.

L'invention cherche, notamment, à vérifier le bon fonctionnement des composants d'une chaîne radio et/ou à calibrer certains des composants de la chaîne.

L'un des objectifs de l'invention est de pouvoir se dispenser d'utiliser des appareils de mesure externes au poste radio et de vérifier le fonctionnement de la chaîne de manière in situ, en cours de fonctionnement.

Ces vérifications sont en général réalisées à la sortie de production des équipements. Toutefois, elles doivent pouvoir être réalisées à n'importe quel moment de la vie d'une chaîne radio et de manière la plus rapide possible afin de ne pas gêner le fonctionnement d'un appareil.

D'autre part, à la connaissance du demandeur, le calibrage des composants radio dans les équipements est réalisé sur des bancs externes à l'aide d'appareils de mesure.

Pour le calibrage d'équipement, le brevet US7932844 présente une méthode itérative pour calibrer des filtres passe-bas avec une chaîne radio spécifique. L'inconvénient est que cette chaîne radio spécifique ne correspond pas à une chaîne classique d'émission ou de réception radio, ce qui signifie qu'il faut adapter la chaîne radio de l'équipement pour pouvoir l'appliquer. Lorsqu'une chaîne radio spécifique n'est pas implémentée, il faut utiliser des appareils de mesure externe pour le calibrage et la vérification des composants radio. L'enseignement technique de ce brevet nécessite de modifier la chaîne et l'utilisation d'appareils de contrôle extérieurs.

L'enseignement technique du document WO 2017/176778 concerne un émetteur/récepteur à auto-étalonnage.

Le document US 2011/0211649 divulgue un procédé pour compenser des interférences dans le cas de l'utilisation de plusieurs canaux de communications.

L'invention concerne un procédé selon les revendications indépendantes. D'autres modes de réalisation sont définis dans les revendications dépendantes.

Les dessins annexés illustrent l'invention :

[Fig.1] représente un exemple de système radio dans lequel le procédé peut être implanté,

[Fig.2] représente le calibrage d'un filtre,

[Fig.3A] est un organigramme des étapes du procédé selon l'invention pour vérifier le fonctionnement correct et acceptable d'une chaîne radio,

[Fig.3B] illustre les étapes du procédé selon l'invention pour la vérification du fonctionnement correct et le calibrage d'un ou de plusieurs filtres dans la chaîne radio,

[Fig.4] illustre la mesure de puissance en sortie d'un filtre à l'initialisation,

[Fig.5] illustre la mesure de puissance en sortie d'un filtre et le calibrage en utilisant la méthode de la sécante,

[Fig.6] représente un exemple d'architecture FPGA permettant d'intégrer le procédé selon l'invention sur une architecture FPGA déjà existante,

[Fig.7] représente un exemple d'architecture FPGA adaptée pour la mise en oeuvre du procédé selon l'invention,

[Fig.8] représente un diagramme de machine à état pour les étapes de calibrage, et

[Fig.9] représente un diagramme de machine à état pour les étapes de calibrage.

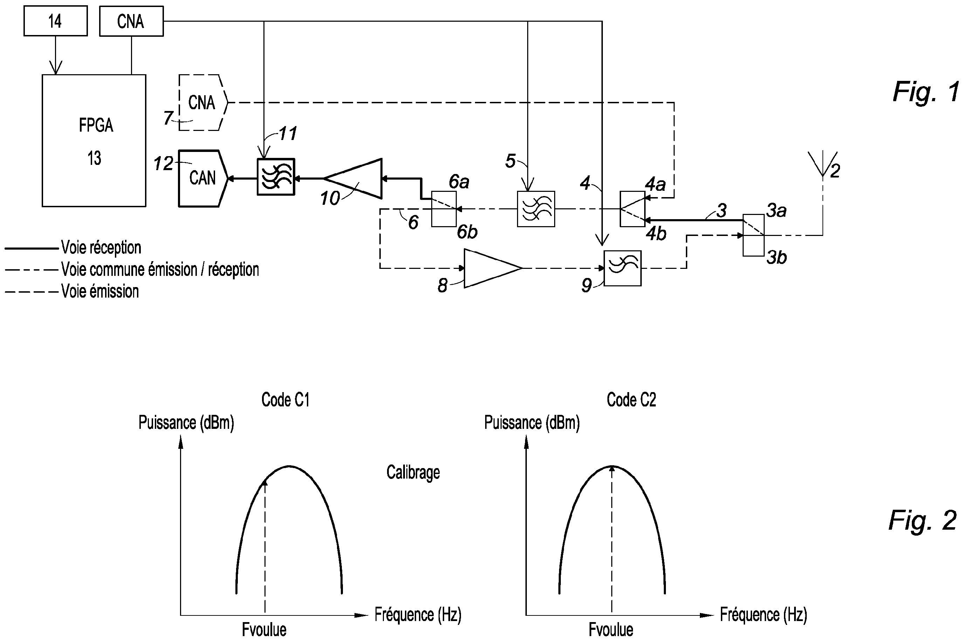

La figure 1 schématise un exemple de dispositif radiofréquence 1 équipé d'un procédé selon l'invention pour réaliser l'autocalibrage des composants de la chaîne, par exemple, le calibrage des filtres.

Une antenne 2 permettant l'émission et/ou la réception de signaux RF est en liaison avec un premier commutateur 3 pouvant prendre deux positions 3a et 3b afin de sélectionner la voie d'émission ou la voie de réception suivant un ordre donné. Un deuxième commutateur 4 et un troisième commutateur 6 sont aussi configurés pour prendre deux positions 4a, 4b, 6a, 6b, selon la voie sélectionnée, respectivement voie émission et voie réception. Ces deux commutateurs sont positionnés en amont d'un premier filtre 5 constituant ainsi une voie commune à la voie d'émission et à la voie de réception.

La voie d'émission comprend un convertisseur numérique analogique 7 relié par la voie commune à un amplificateur de signal 8 et à un filtre 9 positionné en amont de l'antenne.

La chaîne de réception comprend un amplificateur 10 suivi d'un filtre 11 et d'un convertisseur analogique numérique 12.

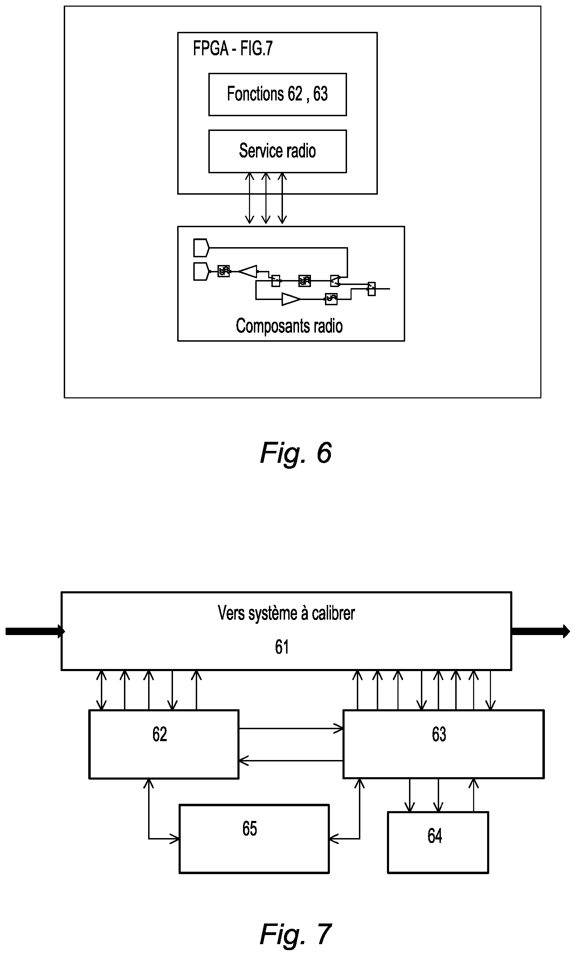

Les différents composants sont commandés par un composant programmable de type FPGA 13 dont un exemple détaillé est illustré en figure 7 ou un dispositif équivalent programmable contenant notamment un processeur configuré pour exécuter les étapes du procédé selon l'invention. Le dispositif comprend aussi un capteur de température 14 relié au FPGA afin de disposer de la valeur de température pour une valeur de fréquence et remonter à un code pour le calibrage d'un composant.

Selon un premier mode de réalisation, le FPGA pilote les composants et les commutateurs de la chaîne radio par le biais d'un bus ou de discrets et positionne la chaîne dans un état de rebouclage, afin de déclencher le procédé de vérification du bon fonctionnement de la chaîne, par exemple. Le FPGA génère ensuite, par exemple, un signal radio en activant les composants de la chaîne émission et envoie un signal de test prédéfini au convertisseur numérique analogique. Par le biais d'un capteur de la chaîne de réception, par exemple le convertisseur analogique numérique, le procédé selon l'invention pour vérifier le bon fonctionnement de la chaîne, va déterminer si les composants de la chaîne réception ou la chaîne commune sont en état de fonctionnement en comparant la valeur de puissance mesurée à une valeur de puissance minimale attendue, par exemple, ou en utilisant tout autre paramètre représentatif du bon fonctionnement des composants de la chaîne radio émission/réception.

Lorsque l'on cherche uniquement à vérifier le bon fonctionnement de la chaîne, le FPGA va déclencher la boucle de mesure de la puissance en sortie de la chaîne de réception, après avoir aiguillé le signal de la chaîne d'émission non pas vers l'antenne d'émission mais vers la chaîne de réception, en positionnant les commutateurs dans un état choisi et donné. Ceci implique le positionnement des commutateurs dans un état donné, comme il est représenté à la figure 1.

Sans sortir du cadre de l'invention, pour vérifier le bon fonctionnement de la chaîne, le procédé peut aussi prendre en compte à la place d'un signal d'émission, une fuite de puissance (courant de fuite) mesurée au niveau du commutateur en liaison avec l'antenne, correspondant au commutateur final lorsque l'on considère la chaîne d'émission et au premier commutateur pour la chaîne de réception, i.e., c'est-à-dire le premier ou dernier commutateur sélectionnant la voie d'émission ou la voie de réception.

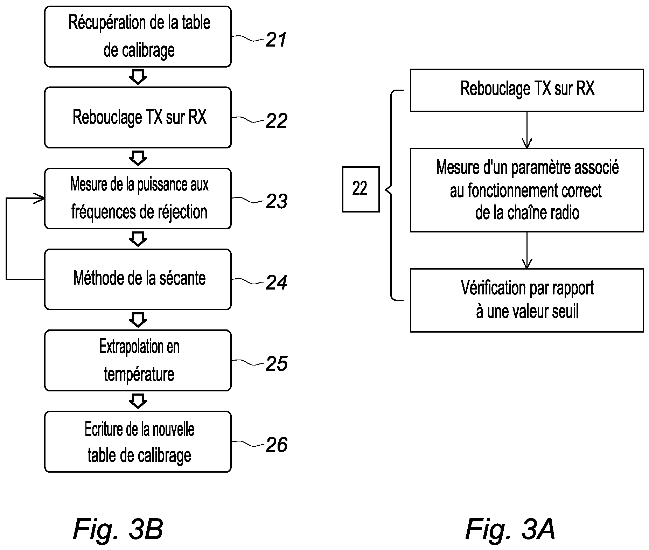

Le procédé peut aussi vérifier simultanément le bon fonctionnement de la chaîne radio et effectuer le calibrage d'un ou de plusieurs composants de la chaîne, notamment le calibrage d'un filtre tractable passe-bande. Pour cela, on va analyser la valeur d'un paramètre représentatif du bon fonctionnement de la chaîne, par exemple, une valeur de puissance au niveau de la chaîne radio émettrice ou la chaîne commune, en utilisant une méthode itérative par exemple, détaillée un peu plus loin dans la description et illustrée à la figure 3B.

Le séquencement général des étapes exécutées par le procédé selon l'invention pour vérifier le calibrage de la chaîne est illustré à la figure 3B.. Selon un autre mode de réalisation, la table pourrait déjà être dans le FPGA. Le FPGA exécute ensuite, après avoir récupéré la table de calibrage, 21, les étapes de calibrage d'un filtre tractable de la chaîne radio émission/réception :

- 22 - on reboucle la chaîne émission sur la chaîne réception, i.e., on envoie le signal émis Se ou à émettre non pas sur l'antenne mais sur la chaîne de réception, via le commutateur 3 et les commutateurs 4 et 6 qui sont en position 3b, 4b, 6b,

- 23 - on mesure, par exemple, la puissance à une première fréquence de réjection supérieure à la fréquence centrale fi du filtre à calibrer et à une deuxième fréquence de réjection inférieure à la fréquence centrale, cette mesure peut être réalisée en sortie de chaîne au niveau du CAN lorsque l'on calibre un seul composant ; lorsque l'on cherche à calibrer plusieurs composants au sein de la chaîne radio, la mesure de puissance pourra se faire après passage du signal dans le composant,

- 24 - on exécute la méthode de la sécante, connue de l'homme du métier, selon un processus itératif sur les deux fréquences de réjection,

- 25 - on extrapole en température,

- 26 - on en déduit une nouvelle table de calibrage associée à un filtre.

- Les étapes 24, 25 et 26 sont par exemple répétées jusqu'à obtenir une table de calibrage complète, c'est-à-dire contenant les valeurs de calibrage pour plusieurs fréquences de référence.

Selon un autre mode de réalisation, à la place d'une table de calibrage, il est possible d'initialiser les étapes avec une valeur de code moyenne obtenue par exemple en réalisant une moyenne sur plusieurs codes mesurés, en utilisant des dispositifs de mesure externes et sur un échantillon représentatif des chaînes radio.

Un exemple est donné pour le calibrage automatique (sans avoir recours à un dispositif externe) d'un filtre tractable passe-bande faisant partie de la chaîne radio. Le FPGA envoie un code au CNA qui le convertit en tension selon un principe connu de l'homme du métier. La tension est transmise à un amplificateur de commande qui l'amplifie et l'applique sur le filtre tractable ou un filtre dont la fréquence centrale peut varier. On obtient alors une table contenant les valeurs des codes aux températures requises et aux fréquences requises (de la table de calibrage). Sans sortir du cadre de l'invention, il est possible d'utiliser d'autres méthodes pour faire varier la fréquence centrale du filtre. Le calibrage des filtres tractables fait appel à une table de calibrage Code(fréquence, température). Pour chaque référence de la table de calibrage, on va trouver les codes optimaux qui permettent de centrer le filtre à calibrer comme il est représenté à la figure 2. La partie gauche de la figure illustre la valeur de puissance mesurée en sortie de filtre avant calibrage et la partie droite de la figure 2 illustre la valeur de puissance mesurée en sortie de filtre après calibrage et en utilisant le procédé selon l'invention.

Pour calibrer le fonctionnement d'un filtre tractable de la chaîne radio, on choisit une fréquence de référence. On effectue ensuite la mesure de la puissance atténuée aux fréquences de réjection. On trouve ensuite le code $c_i$ permettant d'équilibrer le filtre par la méthode de la sécante, selon des étapes connues de l'homme du métier, puis on effectue une extrapolation polynomiale d'ordre 6, par exemple, afin de transposer les codes trouvés à température ambiante aux températures de référence de la table de calibrage, i.e., aux températures de référence indiquées dans la table de calibrage. Toute fonction permettant une extrapolation pourra être utilisée, par exemple une fonction linéaire, polynomiale, etc.

L'algorithme d'auto-calibrage mis en oeuvre dans le FPGA exécute les étapes détaillées ci-après.

Pour chaque filtre à calibrer, pour chaque position, à température ambiante $T_{amb}$, pour chaque fréquence ($f_i$) de la table de calibrage, le FPGA détermine le code $c_i(T_i, f_i)$ qui va permettre de centrer le filtre à calibrer sur cette fréquence ($f_i$) de la table de calibrage. Pour chaque mesure de puissance $P_i$ (effectuée par exemple en sortie de la chaîne radio) on mémorise la température $T_i$ correspondante à la mesure de puissance a été effectuée dans la mémoire du FPGA.

L'algorithme exécuté par le FPGA va chercher à équilibrer les points de réjections d'un filtre à calibrer, en considérant une première fréquence ($f_{i-}$) et une deuxième fréquence ($f_{i+}$). La valeur ($f_{i-}$) peut être égale à ($f_i - \varepsilon$) ou à ($f_i - f_i * \varepsilon$) et la valeur ($f_{i+}$) à ($f_i + \varepsilon$) à ($f_i + f_i * \varepsilon$). La valeur de $\varepsilon$ sera choisie en fonction du composant à calibrer et de l'application radio. Par exemple, dans le cas d'un filtre passe-bande, $\varepsilon$ sera choisi de façon à ce que la puissance du signal à la fréquence centrale $f_i$ soit maximale lorsque les puissances aux deux fréquences de réjection précédemment définies sont égales. Il pourra être déterminé de façon empirique, théorique ou par la modélisation des filtres à calibrer. La valeur de $\varepsilon$ pourra être différente suivant la bande de fréquence ou suivant la fréquence de réjection considérée (inférieure ou supérieure).

Pour équilibrer les deux fréquences $f_{i-}$ et $f_{i+}$, le FPGA applique la méthode de la sécante connue de l'homme du métier. On va rechercher le « 0 » de la fonction :

$$g(c) = P_c(\mathrm{f}_{i+}) - P_c(\mathrm{f}_{i-})$$

où Pc(f) est la puissance mesurée à la fréquence f lorsque le code c est programmé. Il s'agit de la réponse fréquentielle du filtre à la fréquence f. On dispose alors d'une mesure de puissance à la fréquence de réjection inférieure à la fréquence $f_i$ et une mesure de puissance à la fréquence de réjection supérieure à la fréquence $f_i$.

Le procédé va, par exemple, initialiser deux valeurs de code proches des valeurs de codes pour une température donnée et contenues dans la table de calibrage prédéfinie ou une table obtenue lors de la mise en oeuvre du procédé selon l'invention. Le FPGA considère la table de calibrage initiale ou une table constituée de valeurs obtenues lors d'une étape de calibrage antérieure. La mesure de la température ambiante est effectuée par le capteur de température en liaison avec le FPGA puis, ce dernier va rechercher dans la table de calibrage, la valeur du code correspondant à la fréquence recherchée, pour une température inférieure à la température ambiante dans la table de calibrage. Le code trouvé correspond au premier point :

- $g_1 \leftarrow g(code_1)$
- $nb_{iteration} \leftarrow limite\ ITER$
- Tant que $abs(code_2 - code_1) > limite\ PREC$ et que $nb_{iteration} > 0$ alors $g_2 \leftarrow g(code_2)$.

  ○

$$code_3 \leftarrow code_2 + \frac{code_2 - code_1}{g_2 - g_1} g_2$$

  ○ $code_1 \leftarrow code_2$
  ○ $code_2 \leftarrow code_3$
  ○ $g_1 \leftarrow g_2$
  ○ $nb_{iteration} \leftarrow nb_{iteration} - 1$

La limite ITER correspond à un nombre d'itérations défini, par exemple, en fonction du temps maximal alloué à l'étape de calibrage ou de la résolution du composant utilisé pour mesurer la puissance, par exemple le CAN. La limite PREC correspond à une valeur d'écart entre les codes et à un seuil de précision souhaité qui est notamment défini en fonction de la sensibilité du capteur de température.

On obtient alors une suite de points permettant d'associer les fréquences de la table avec des codes et à des températures mesurées. Ensuite, on extrapole les mesures pour obtenir les codes aux niveaux de température requis contenus dans la table de calibrage et non plus à la température de mesure. L'étape d'extrapolation est exécutée selon un principe connu de l'homme du métier.

On obtient alors une table contenant les valeurs des codes aux températures requises et aux fréquences requises (fréquences de la table de calibrage). Cette table sera stockée, par exemple, par le FPGA pour une utilisation ultérieure. Pour une fréquence positionnée entre deux fréquences, mais qui n'est pas contenue dans la table de calibrage, le FPGA qui programme le signal radio réalise une interpolation en prenant comme entrées le code de la fréquence de référence inférieure et le code de la fréquence de référence supérieure à la fréquence souhaitée.

La mise en oeuvre du procédé selon l'invention est réalisée, par exemple, dans un composant programmable FPGA comprenant notamment des modules de commande permettant l'exécution du procédé selon l'invention. Pour cela, le FPGA peut utiliser une architecture de processeur pour FPGA connu sous le terme anglo-saxon « softcore ».

Cette architecture possède les avantages suivants :

- La flexibilité : il est possible de modifier l'algorithme sans remettre en cause l'architecture du FPGA,

- La versatilité : il est possible d'utiliser ce softcore pour d'autres besoins éventuels (canaux bouchés...),

- capacité de débogage (utilisation de point d'arrêt « breakpoint »),

- capacité d'accélération de mise au point : une modification de l'algorithme ne demande qu'une compilation (quelques dizaines de secondes) plutôt qu'une synthèse-placement-routage selon l'art antérieur (quelques dizaines de minutes).

Selon un autre mode de réalisation, il est possible d'envisager une architecture matériel pour la mise en oeuvre du procédé selon l'invention basée sur l'utilisation de plusieurs machines d'états codées, par exemple, en langage de description matériel destiné à représenter le comportement ainsi que l'architecture numérique connu sous l'acronyme anglo-saxon suivant VHSIC Hardware Description Language, avec VHSIC = Very High Speed Integrated Circuit et des blocs de calcul codés en VHDL.

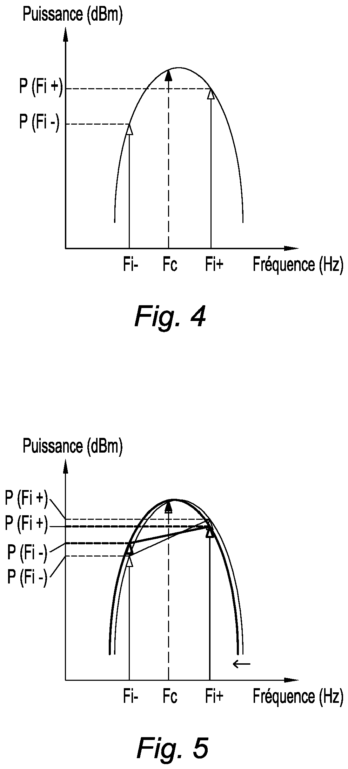

La figure 4 illustre la mesure de puissance en sortie d'un filtre à l'initialisation, et la figure 5 la mesure de puissance en sortie d'un filtre et le calibrage en utilisant la méthode de la sécante. Pour que le signal à la fréquence centrale ait une puissance maximale, on cherche à équilibrer le filtre en ayant des puissances aux fréquences de réjection Fi- et Fi+ égales

La figure 6 illustre un exemple d'agencement d'un FPGA détaillé à la figure 7 en liaison avec la chaîne radio de la figure 1 comprenant un module d'autocalibrage détaillé à la figure 7 permettant de calibrer un ou plusieurs composants.

La figure 7 illustre un exemple d'architecture de bloc dans le cas d'une implémentation matérielle.

Les blocs principaux sont les suivants:

- Autocal_comm 61 : permettant la communication entre le service du FPGA réalisant la gestion du calibrage et les autres services du FPGA, et notamment le service qui s'occupe de convertir les demandes d'accès radio en commandes pour les composants radio analogiques. Dans un souci d'optimisation de ressources, on pourra y ajouter une machine d'état permettant de partager un noeud émetteur TX.

- Fsm_autocal_main 62: machine à état principale permettant de contrôler les étapes principales de l'auto-calibrage, notamment les étapes d'initialisation et de finalisation de l'opération ainsi que les incréments dans les configurations de la chaîne radiofréquence.

- Fsm_autocal_balance 63 : machine à état mettant en place l'algorithme « d'équilibrage » des deux fréquences de coupure. C'est elle qui implémente la méthode de la sécante.

- Polynom_horner 64: bloc de calcul permettant d'évaluer un polynôme. Ce bloc permet d'évaluer un polynôme et de déporter le calcul de l'extrapolation en température.

- Autocal_mem 65 : mémoire de calcul étant une copie de la mémoire contenant la carte de calibrage. Elle est chargée à l'initialisation de l'opération d'auto-calibrage, elle est utilisée en tant que mémoire de calcul par le bloc fsm_autocal_balance. Lorsque l'opération est terminée, elle est recopiée dans la mémoire d'origine contenant la table de calibrage afin de rendre le résultat persistant.

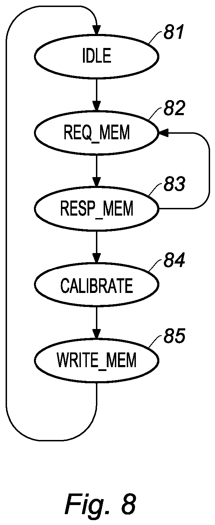

La machine à état fsm_autocal_main 62 peut être représentée par le diagramme de la figure 8.

Dans l'état IDLE, 81, la machine attend une commande de démarrage de l'opération d'auto-calibrage. À la réception de ce message, la machine à états finis ou FSM demande au service du FPGA qui gère les composants radio de passer en mode auto-calibrage (démarrage du CNA avec des échantillons à -30 dBm).

Dans l'état REO_MEM, 82, la machine d'état récupère la table de calibrage dans sa mémoire de stockage.

Dans l'état RESP_MEM, 83, la machine d'état attend que la réponse à la requête précédemment générée arrive. Ensuite, elle écrit cette réponse dans la mémoire autocal_mem. La machine part dans l'état CALIBRATE si toute la table a été chargée, sinon elle repart en REO_MEM.

Dans l'état CALIBRATE, 84, la machine déclenche des requêtes vers la machine d'état secondaire (fsm_autocal_balance) successivement pour chaque fréquence à calibrer.

La machine profite de l'état CALIBRATE pour configurer les discrets de manière à réaliser cette configuration. Lorsque toutes les configurations ont été calculées, la machine passe dans l'état WRITE_MEM.

Dans l'état WRITE_MEM, 85, la machine réécrit en EEPROM la mémoire précédemment calculée.

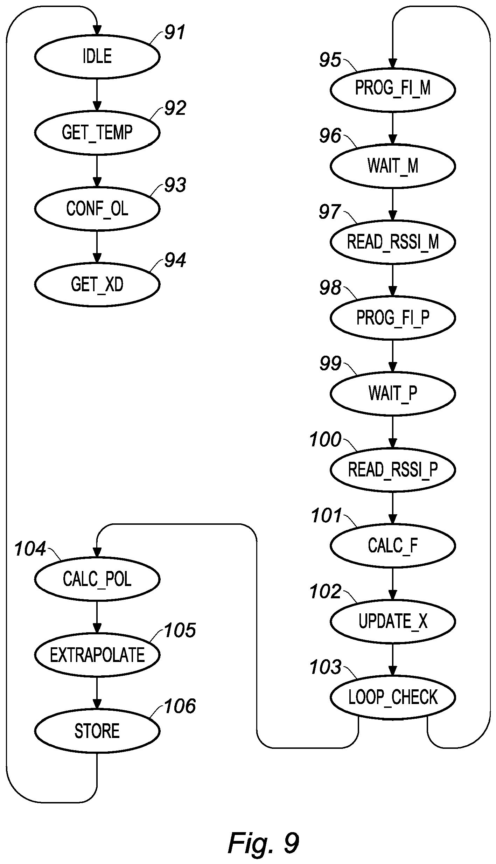

La machine à état fsm_autocal_balance peut être représentée par le diagramme illustré à la figure 9.

Dans l'état IDLE, 91, la machine attend une commande de démarrage de l'opération d'équilibrage des fréquences avec les numéros de filtre, configuration et fréquence (provenant de la fsm_autocal_main). À la réception de cette commande, la FSM fait une requête de température.

Dans l'état GET_TEMP, 92, la machine attend une réponse à la requête de température précédemment envoyée et stocke la valeur reçue qui servira pour l'extrapolation en température.

Dans l'état CONF_OL, 93, la machine mémorise les configurations.

Dans l'état GET_X0, 94, la machine à état récupère le code correspondant à la fréquence demandée à la température directement inférieure à la température ambiante et le stock dans un registre X.

Dans l'état PROG_FI_M, 95, la machine d'état configure les oscillateurs locaux OL, non représentés sur la figure, pour la fréquence Fi-.

Dans l'état WAIT_M, 96, la machine d'état attend pour que toutes les valeurs à mesurer soient stables. La valeur de la puissance mesurée est récupérée.

Dans l'état READ_RSSI_M, 97, la machine d'état récupère les valeurs des puissances (les valeurs brutes peuvent suffire, il n'y a pas besoin de convertir ces valeurs en dBm).

Dans l'état PROG_FI_P, 98, la machine d'état configure les OL pour la fréquence Fi+.

Dans l'état WAIT_P, 99, la machine d'état attend pour que toutes les valeurs à mesurer soient stables. Lorsque le temps est écoulé, une requête de puissance est envoyée.

Dans l'état READ_RSSI_P, 100, la machine d'état récupère les valeurs des puissances.

Dans l'état CALC_F, 101, la machine calcule la différence des puissances reçues.

Dans l'état UPDATE_X, 102, la machine à un comportement différent selon s'il s'agit de son premier passage depuis l'état IDLE :

- Dans le cas du premier passage, la machine récupère le code correspondant à la fréquence demandée à la température directement inférieure à la température ambiante et le stocke dans le registre X, le registre X dans X_prev et la valeur de F dans F_prev.

- Dans le cas d'un autre passage, la machine calcule X selon la formule de la sécante et stocke cette nouvelle valeur dans X, tandis que X est stocké dans X_prev et F dans F_prev.

Dans l'état LOOP_CHECK, 103, la machine vérifie l'écart entre X et X_prev ainsi que le nombre d'itération et choisi le prochain état en fonction.

Dans l'état CALC_POL, 104, la machine attend la valeur du polynôme associé au filtre pour la fréquence donnée. Cette valeur sera utilisée pour l'extrapolation. La valeur du polynôme est calculée par un bloc extérieur.

Dans l'état, EXTRAPOLATE, 105, la machine effectue l'opération permettant le calcul d'extrapolation en tenant compte de la température mesurée et de la température recherchée.

Dans l'état STORE, 106, le résultat de l'extrapolation est stocké en mémoire, le calcul est réitéré pour chaque température recherchée. Quand toutes les températures sont traitées, la machine repasse en état IDLE en envoyant un acquittement à la machine fsm_autocal_main.

L'invention offre un procédé de calibrage rapide, qui ne nécessite pas d'utilisation de dispositifs extérieurs.

**Revendications**

1. Procédé pour vérifier le fonctionnement d'une chaîne radio comprenant au moins une chaine d'émission de signal radio, une chaine de réception d'un signal radio, et au moins un filtre à calibrer ayant une fréquence central ($f_i$) et des fréquences de rejection, le signal émis par ladite chaine d'émission étant aiguillé vers ladite chaine de réception suivant un ordre donné par au moins un commutateur positionné dans la chaîne radio pour aiguiller un signal de test de la chaîne d'émission vers la chaîne de réception, **caractérisé en ce que** le procédé comporte au moins les étapes suivantes :

- émettre à partir de la chaîne d'émission radio un signal de test pour vérifier le fonctionnement correct de la chaîne radio, lesdites chaines d'émission et de réception comprenant une voie commune, ledit signal de test étant transmis sur la voie commune vers ledit au moins un filtre puis vers au moins un élément de mesure de ladite chaîne radio, ledit au moins un filtre étant positionné sur ladite voie commune et ledit au moins un élément de mesure étant positionné sur ladite chaine de réception, et **en ce que**, pour chaque filtre à calibrer, le procédé comprend une étape de calibrage comprenant les étapes consistant à :

- mesurer la valeur de puissance dudit signal de test, après passage dans le filtre à calibrer, pour chaque fréquence contenue dans une table de calibrage, la table de calibrage contenant des codes $c_i(T_i, f_i)$ correspondant chacun à une fréquence $f_i$ et une température de référence $T_i$, et mesurer la valeur de la température ambiante associée à ladite mesure de puissance,
- exécuter un processus itératif de la méthode de la sécante sur toutes les fréquences de réjection associées audit filtre pour trouver des codes, effectuer une extrapolation polynomiale d'ordre 6 pour transposer lesdits codes trouvés à température ambiante à la température de référence $T_i$, et déterminer un code optimal pour équilibrer le filtre pour chacune des valeurs desdites valeurs de fréquence et de température.

2. Procédé selon la revendication 1, **caractérisé en ce qu'**il comporte en outre une étape d'initialisation de la table de calibrage comprenant une étape consistant à réaliser une valeur moyenne sur plusieurs codes mesurés en utilisant au moins un dispositif de mesure externe.

3. Procédé selon l'une des revendications 1 ou 2, **caractérisé en ce que** le signal de test est un courant de fuite présent dans ledit au moins un commutateur de la chaîne radio.

4. Système pour vérifier le fonctionnement d'une chaîne radio comprenant au moins une chaîne d'émission d'un signal et une chaîne de réception d'un signal, **caractérisé en ce qu'**il comporte un dispositif de gestion et de commande configuré pour exécuter les étapes du procédé selon l'une des revendications 1 à 3.

5. Système selon la revendication 4, **caractérisé en ce qu'**il comporte au moins les éléments suivants :

   - une chaîne d'émission comprenant un convertisseur analogique numérique (7) relié à un amplificateur de signal (8) et à un filtre (9) positionné en amont d'une antenne (2),
   - une chaîne de réception comprenant un amplificateur (10) positionné en amont d'un filtre dont la fréquence centrale est variable (11), et un convertisseur analogique numérique (12),

   et **en ce que** ladite antenne est liée avec un premier commutateur (3) configuré pour prendre deux positions (3a, 3b) afin de sélectionner la chaîne d'émission ou la chaine de réception suivant ledit ordre donné par un dispositif de gestion et de commande (13), un deuxième commutateur (4) et un troisième commutateur (6) configurés pour prendre deux positions (4a, 4b, 6a, 6b), selon la voie sélectionnée parmi la chaîne d'émission et la chaine réception, lesdits deux commutateurs sont positionnés en amont d'un premier filtre (5) constituant ainsi une voie commune à la chaîne d'émission et à la chaine de réception.

6. Système selon la revendication 5, **caractérisé en ce que** la chaîne d'émission comprend au moins un filtre tractable.

7. Système selon l'une des revendications 4 à 6, **caractérisé en ce que** le dispositif de gestion et de commande est un dispositif de type FPGA configuré pour agir sur les commutateurs afin d'activer la chaîne d'émission ou la chaîne de réception et de contrôle du bon fonctionnement de la chaîne radio.

8. Système selon l'une des revendications 6 ou 7, **caractérisé en ce qu'**il comporte un convertisseur numérique analogique CNA relié au FPGA, ledit CNA recevant un code émis par le FPGA afin de le convertir en une tension appliquée au filtre afin de générer une table contenant les valeurs des codes aux températures requises et aux fréquences requises d'une table de calibrage.

**Patentansprüche**

1. Verfahren zum Überprüfen des Betriebs eines Funkkanals, der mindestens einen Funksignalsendekanal, einen Funksignalempfangskanal und mindestens ein zu kalibrierendes Filter mit einer Mittenfrequenz ($f_i$) und Unterdrückungsfrequenzen umfasst, wobei das von dem Sendekanal gesendete Signal in einer von mindestens einem in dem Funkkanal positionierten Schalter gegebenen Reihenfolge zum Empfangskanal geleitet wird, um ein Testsignal von dem Sendekanal zum Empfangskanal zu leiten, **dadurch gekennzeichnet, dass** das Verfahren mindestens die folgenden Schritte aufweist:

   - Senden eines Testsignals von dem Funksendekanal zum Überprüfen des korrekten Betriebs des Funkkanals, wobei der Sende- und der Empfangskanal einen gemeinsamen Kanal umfassen, wobei das Testsignal auf dem gemeinsamen Kanal zu dem mindestens einen Filter und dann zu mindestens einem Messelement des Funkkanals übertragen wird, wobei das mindestens eine Filter auf dem gemeinsamen Kanal positioniert ist und das mindestens eine Messelement auf dem Empfangskanal positioniert ist,

   und dadurch, dass das Verfahren für jedes zu kalibrierende Filter einen Kalibrierungsschritt umfasst, der die folgenden Schritte umfasst:

   - Messen des Leistungswerts des Testsignals nach Durchlaufen des zu kalibrierenden Filters für jede in einer Kalibrierungstabelle enthaltene Frequenz, wobei die Kalibrierungstabelle Codes $c_i(T_i,f_i)$ enthält, die jeweils einer Frequenz $f_i$ und einer Referenztemperatur $T_i$ entsprechen, und Messen des der Leistungsmessung zugeordneten Werts der Umgebungstemperatur,
   - Ausführen eines iterativen Prozesses des Sekantenverfahrens über alle dem Filter zugeordneten Unterdrückungsfrequenzen, um Codes zu finden, Durchführen einer Polynomextrapolation der Ordnung 6, um die gefundenen Codes bei Umgebungstemperatur auf die Referenz-

temperatur $T_i$ zu transponieren, und Bestimmen eines optimalen Codes zum Ausgleichen des Filters für jeden der Werte der Frequenz- und Temperaturwerte.

2. Verfahren nach Anspruch 1, **dadurch gekennzeichnet, dass** es ferner einen Schritt des Initialisierens der Kalibrierungstabelle aufweist, der einen Schritt des Realisierens eines Mittelwerts über mehrere Codes umfasst, die unter Verwendung von mindestens einer externen Messvorrichtung gemessen werden.

3. Verfahren nach Anspruch 1 oder 2, **dadurch gekennzeichnet, dass** das Testsignal ein Leckstrom ist, der in dem mindestens einen Schalter des Funkkanals vorhanden ist.

4. System zum Überprüfen des Betriebs eines Funkkanals, der mindestens einen Kanal zum Senden eines Signals und einen Kanal zum Empfangen eines Signals umfasst, **dadurch gekennzeichnet, dass** es eine Verwaltungs- und Steuervorrichtung umfasst, die zum Ausführen der Schritte des Verfahrens nach einem der Ansprüche 1 bis 3 konfiguriert ist.

5. System nach Anspruch 4, **dadurch gekennzeichnet, dass** es mindestens die folgenden Elemente aufweist:

   - einen Sendekanal, der einen Analog-Digital-Wandler (7) umfasst, der mit einem Signalverstärker (8) und einem stromaufwärts von einer Antenne (2) positionierten Filter (9) verbunden ist,
   - einen Empfangskanal, der einen stromaufwärts von einem Filter mit variabler Mittenfrequenz (11) positionierten Verstärker (10) und einen Analog-Digital-Wandler (12) umfasst,

   und dadurch, dass die Antenne mit einem zum Einnehmen von zwei Positionen (3a, 3b) konfigurierten ersten Schalter (3) zum Auswählen des Sendekanals oder des Empfangskanals gemäß der von einer Verwaltungs- und Steuervorrichtung (13) gegebenen Reihenfolge, einem zweiten Schalter (4) und einem dritten Schalter (6) verbunden ist, die zum Einnehmen von zwei Positionen (4a, 4b, 6a, 6b) konfiguriert sind, je nachdem, welcher Kanal aus dem Sendekanal und dem Empfangskanal ausgewählt ist, wobei die beiden Schalter stromaufwärts von einem ersten Filter (5) positioniert sind, womit ein gemeinsamer Kanal für den Sendekanal und den Empfangskanal gebildet wird.

6. System nach Anspruch 5, **dadurch gekennzeichnet, dass** der Sendekanal mindestens ein abstimmbares Filter umfasst.

7. System nach einem der Ansprüche 4 bis 6, **dadurch gekennzeichnet, dass** die Verwaltungs- und Steuervorrichtung eine Vorrichtung des FPGA-Typs ist, die so konfiguriert ist, dass sie auf die Schalter einwirkt, um den Sendekanal oder den Empfangskanal zu aktivieren und den ordnungsgemäßen Betrieb des Funkkanals zu überwachen.

8. System nach Anspruch 6 oder 7, **dadurch gekennzeichnet, dass** es einen mit dem FPGA verbundenen Digital-Analog-Wandler DAC aufweist, wobei der DAC einen vom FPGA gesendeten Code empfängt, um ihn in eine an das Filter angelegte Spannung umzuwandeln, um eine Tabelle zu erzeugen, die die Werte der Codes bei den erforderlichen Temperaturen und den erforderlichen Frequenzen einer Kalibrierungstabelle enthält.

## Claims

1. A method for checking the operation of a radio channel comprising at least one radio signal-emitting channel, one channel for receiving a radio signal, and at least one filter to be calibrated, having a central frequency ($f_i$) and rejection frequencies, the signal emitted by said emitting channel being routed to said receiving channel in a given order by at least one switch positioned in the radio channel to route a test signal from the emitting channel to the receiving channel, **characterised in that** the method contains at least the following steps:

   - emitting, from the radio emitting channel, a test signal for checking the correct operation of the radio channel, said emitting and receiving channels comprising a common channel, said test signal being transmitted over the common channel to said at least one filter, then to at least one element for measuring said radio channel, said at least one filter being positioned on said common channel and said at least one measuring element being positioned on said reception channel,

   and **in that**, for each filter to be calibrated, the method comprises a calibration step comprising the steps of:

   - measuring the power value of said test signal, after passage through the filter to be calibrated, for each frequency contained in a calibration table, the calibration table containing codes $c_i(T_i, f_i)$ which each correspond to a frequency $f_i$, and a reference temperature $T_i$, and measuring the value of the ambient temperature associated with said power measurement,
- executing an iterative secant-method process on all the rejection frequencies associated with said filter for finding the codes, performing a polynomial extrapolation of order 6 to transpose said codes found at ambient temperature to the reference temperatures $T_i$, and determining an optimal code for balancing the filter for each of the values of said frequency and temperature values.

2. The method according to claim 1, **characterised in that** it further contains a step of initialising the calibration table, comprising a step of performing an average value over several codes measured using at least one external measuring device.

3. The method according to one of claim 1 or 2, **characterised in that** the test signal is a leakage current present in said at least one switch of the radio channel.

4. A system for checking the operation of a radio channel comprising at least one channel for emitting a signal and one channel for receiving a signal, **characterised in that** it contains a managing and controlling device configured to execute the steps of the method according to one of claims 1 to 3.

5. The system according to claim 4, **characterised in that** it contains at least the following elements:

   - an emitting channel comprising an analogue-digital converter (7) connected to a signal amplifier (8) and to a filter (9) positioned upstream of an antenna (2),
   - a receiving channel comprising an amplifier (10) positioned upstream of a filter (11) the central frequency of which is variable, and an analogue-digital converter (12),

   and **in that** said antenna is connected to a first switch (3) that is configured to take two positions (3a, 3b) in order to select the emitting channel or the receiving channel in said order given by a managing and controlling device (13), a second switch (4) and a third switch (6), the latter two configured to take two positions (4a, 4b, 6a, 6b), depending on the channel selected from among the emitting channel and the receiving channel, said two switches being positioned upstream of a first filter (5), thus forming a channel that is common to the emitting channel and the receiving channel.

6. The system according to claim 5, **characterised in that** the emitting channel comprises at least one tunable filter.

7. The system according to one of claims 4 to 6, **characterised in that** the managing and controlling device is a device of FPGA type configured to act on the switches in order to activate the emitting channel or the receiving channel and for monitoring the correct operation of the radio channel.

8. The system according to one of claim 6 or 7, **characterised in that** it contains a digital-analogue converter, DAC, connected to the FPGA, said DAC receiving a code emitted by the FPGA in order to convert it into a voltage applied to the filter in order to generate a table containing the values of the codes at the required temperatures and at the required frequencies of a calibration table.

*Fig. 1*

Voie réception
Voie commune émission / réception
Voie émission

14

CNA

FPGA
13

CNA
7

11

12 CAN

10

6a
6
6b

5

4
4a
4b

3
3a
3b

2

8

9

EP 3 675 391 B1

Code C1

Puissance (dBm)

Calibrage

Fréquence (Hz)

Fvoulue

Code C2

Puissance (dBm)

Fréquence (Hz)

Fvoulue

*Fig. 2*

Récupération de la table
de calibrage — 21

⇩

Rebouclage TX sur RX — 22

⇩

Mesure de la puissance aux
fréquences de réjection — 23

⇩

Méthode de la sécante — 24

⇩

Extrapolation en
température — 25

⇩

Ecriture de la nouvelle
table de calibrage — 26

*Fig. 3B*

22

Rebouclage TX sur RX

↓

Mesure d'un paramètre associé
au fonctionnement correct
de la chaîne radio

↓

Vérification par rapport
à une valeur seuil

*Fig. 3A*

*Fig. 4*

*Fig. 5*

FPGA - FIG.7

Fonctions 62 , 63

Service radio

Composants radio

*Fig. 6*

Vers système à calibrer

61

62

63

65

64

*Fig. 7*

*Fig. 8*

*Fig. 9*

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 7932844 B
- WO 2017176778 A
- US 20110211649 A